# FASCICULE DE BREVET EUROPEEN

(11) **EP 0 736 964 B1**
(45) Date de publication et mention de la délivrance du brevet: **15.01.2003**
(21) Numéro de dépôt: 96400749.6
(22) Date de dépôt: 05.04.1996
(51) Int. Cl.: H02P 8/34, G01D 11/16

(54) **Système d'entraînement à base de moteur pas à pas comprenant des moyens perfectionnés de remise à zéro**
Basisantriebssystem für einen Schrittmotor mit verbesserter Rücksetzschaltung
Basic device system for a stepping motor having improved reset means

(30) Priorité: 07.04.1995 FR 9504166
(43) Date de publication de la demande: 09.10.1996
(73) Titulaire: MAGNETI MARELLI FRANCE, 92000 Nanterre (FR)
(72) Inventeur: Marteau, Bernard, 91430 Igny (FR)
(74) Mandataire: Texier, Christian

(56) Documents cités:
- EP-A- 0 080 025
- EP-A- 0 382 887
- EP-A- 0 403 691
- WO-A-96/01412
- DE-A- 4 310 060
- FR-A- 2 686 414

## Description

La présente invention concerne le domaine des systèmes d'entraînement à base de moteur pas à pas. Elle s'applique en particulier aux indicateurs à moteurs pas à pas.

Les moteurs pas à pas comprennent généralement un stator comprenant un circuit magnétique et plusieurs enroulements (typiquement deux) définissant N paires de pôles lesquels sont alternativement nord et sud, et un rotor coaxial au stator, qui possède X paires de pôles. L'alimentation des enroulements à l'aide d'une tension électrique contrôlée, par exemple des signaux proportionnels au sinus et cosinus de l'angle recherché, génère un champ magnétique rotatif suivi par le rotor.

On a déjà proposé de nombreux systèmes comprenant un organe entraîné par un moteur pas à pas. En particulier, on a proposé de réaliser des indicateurs électriques en fixant une aiguille sur l'arbre d'un moteur pas à pas ou en reliant indirectement cette aiguille audit arbre, par exemple à l'aide d'un système d'engrenage, de sorte que l'aiguille soit déplacée devant un cadran de mesure. Pour celà le moteur reçoit, d'un circuit de commande, une séquence de signaux apte à l'amener par déplacements successifs dans une position angulaire par rapport à une référence, telle que cette position soit représentative de la valeur de la grandeur à indiquer.

On a notamment proposé d'utiliser de tels indicateurs à base de moteurs pas à pas, dans le domaine des tableaux de bord pour véhicules automobiles.

L'un des problèmes à résoudre lorsque l'on utilise un moteur pas à pas, notamment mais non exclusivement dans le cadre de ce type d'application des moteurs pas à pas pour la réalisation d'indicateurs, est de pouvoir ramener l'organe entraîné (par exemple l'aiguille) sur sa position de référence, appelée généralement position de zéro, lorsque la tension d'alimentation (par exemple la tension du réseau de bord) est interrompue ou que la tension (de bord) disparait temporairement puis réapparaît ou encore à chaque initialisation du système (par exemple chaque initialisation de l'indicateur). En effet le moteur peut avoir accumulé un certain nombre de pas supplémentaires ou avoir perdu un certain nombre de pas, sous l'action d'un blocage ou d'une sollictation mécanique et on ne peut être certain que sous l'action d'une séquence de signaux de commande correspondant à un déplacement d'un angle inverse de celui qui correspond à sa position de consigne au moment où on déclenche l'ordre de retour au zéro, il regagne avec certitude sa position dite "de référence" ou "de zéro".

Il a été envisagé de placer une butée mécanique pour le rotor, coïncidant avec la position de zéro, sur le système, et d'appliquer sur les enroulements du stator une séquence de signaux pour la commande du moteur en sens rétrograde, comportant un nombre de cycles suffisant pour garantir que la butée mécanique soit atteinte. Cependant, cette disposition conduit à des inversions cycliques de couple moteur lorsque les signaux de commande sont appliqués après que la butée soit atteinte. Cette disposition génère par conséquent des oscillations indésirables du système (par exemple de l'aiguille).

Différentes solutions ont été proposées pour tenter de résoudre ces problèmes.

Une première solution peut consister à placer une butée pour un élément lié au rotor, par exemple pour l'aiguille, au niveau de la position de zéro, et à assurer le retour du moteur pas à pas en position de zéro à l'aide d'un ressort préarmé. Une telle solution est par exemple décrite dans le document FR-A-2 686 414. Cette solution présente cependant des inconvénients de coût. Elle nécessite en outre d'augmenter le couple moteur, pour armer le ressort.

Une seconde solution (voir EP-A-0382887 et EP-A-0403691) peut consister, toujours en plaçant une butée pour le rotor au niveau de la position de zéro, à exploiter un signal qui varie sur une bobine du stator non commandée, au moment ou cette butée est atteinte, sous l'action d'une séquence de signaux de commande de rotation du moteur en sens rétrograde, pour arrêter ladite séquence de commande et l'alimentation du moteur. Cette solution entraîne une électronique complexe et difficile à intégrer car elle nécessite à la fois deux transistors de puissance pour commander un enroulement et des circuits à haute impédance d'entrée pour recueillir un signal utile.

Une troisième solution peut consister à détecter la position de zéro grâce à un capteur approprié, par exemple un capteur optique, un capteur à effet Hall ou un moyen équivalent. Selon une variante de cette solution on peut détecter le franchissement non pas de la position de zéro, mais une position décalée d'un angle connu par rapport à cette position de zéro, et assurer ensuite le retour en position de zéro, à partir de cette position connue, grâce à une séquence de commande appropriée. Cette solution conduit à un indicateur relativement onéreux en raison de la présence du capteur.

La présente invention a maintenant pour but de perfectionner les systèmes d'entraînement à base de moteur pas à pas, notamment les indicateurs à moteurs pas à pas, en proposant de nouveaux moyens de remise à zéro.

Le document WO-96/01412 qui n'a été publié que postérieurement à la date de priorité revendiquée dans la présente demande de brevet européen décrit différents processus de contrôles des signaux électriques de commande appliqués aux enroulements d'un moteur lors d'une remise à zéro de celui-ci conte une butée mécanique. L'un des processus décrit dans ce document WO-A-96/01412 consiste à réduire progressivement l'amplitude des signaux électriques appliqués aux enroulements stator de sorte que le couple moteur soit progressivement réduit avant d'atteindre la butée mécanique.

Ce but est atteint selon la présente invention grâce à un système du type défini en revendication 1 annexée.

D'autres caractéristiques, buts et avantages de la présente invention apparaitront à la lecture de la description détaillée qui va suivre et en regard des dessins annexés, donnés à titre d'exemple non limitatif, et sur lesquels :
- la figure 1 représente une vue schématique des pôles générés par un bobinage de stator conforme à la présente invention,
- la figure 2 représente schématiquement le signal permettant de déplacer le moteur d'un cycle magnétique,
- la figure 3 représente schématiquement la coopération d'une butée mécanique liée au stator et d'une butée mécanique prévue sur une came liée au rotor,
- la figure 4 représente schématiquement la structure de moyens de commande conformes à un mode de réalisation de la présente invention,
- la figure 5 représente schématiquement un chronogramme des signaux de commande appliqués au moteur selon un mode de réalisation préférentiel de l'invention,
- la figure 6 représente schématiquement une séquence de signaux de commande en sens rétrograde pour le moteur conforme à la présente invention,

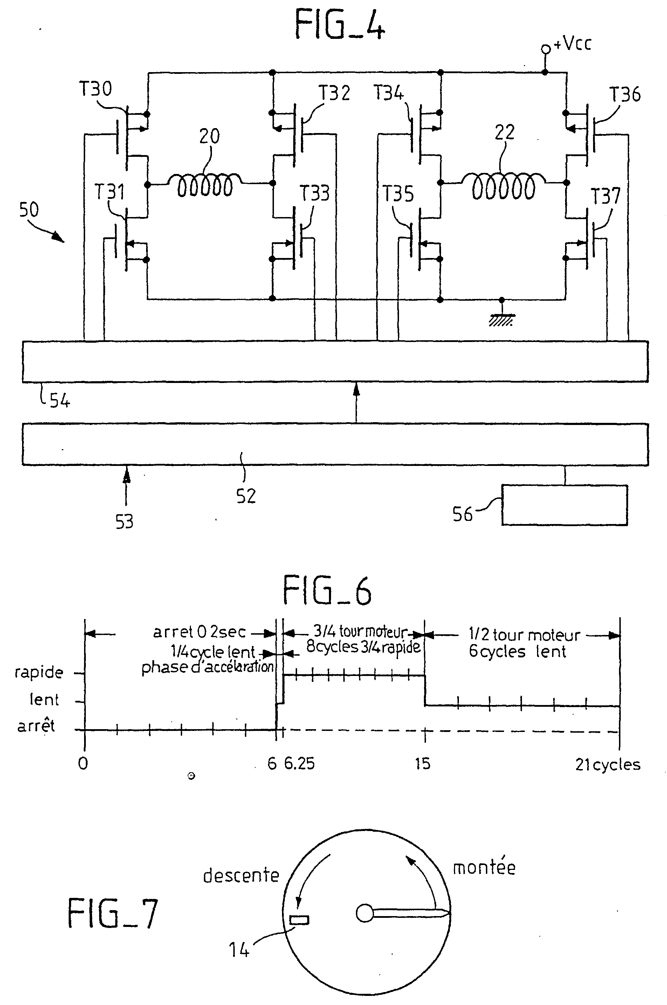

- la figure 6bis représente une variante d'une telle séquence, et
- la figure 7 représente une vue schématique face avant d'un indicateur conforme à la présente invention.

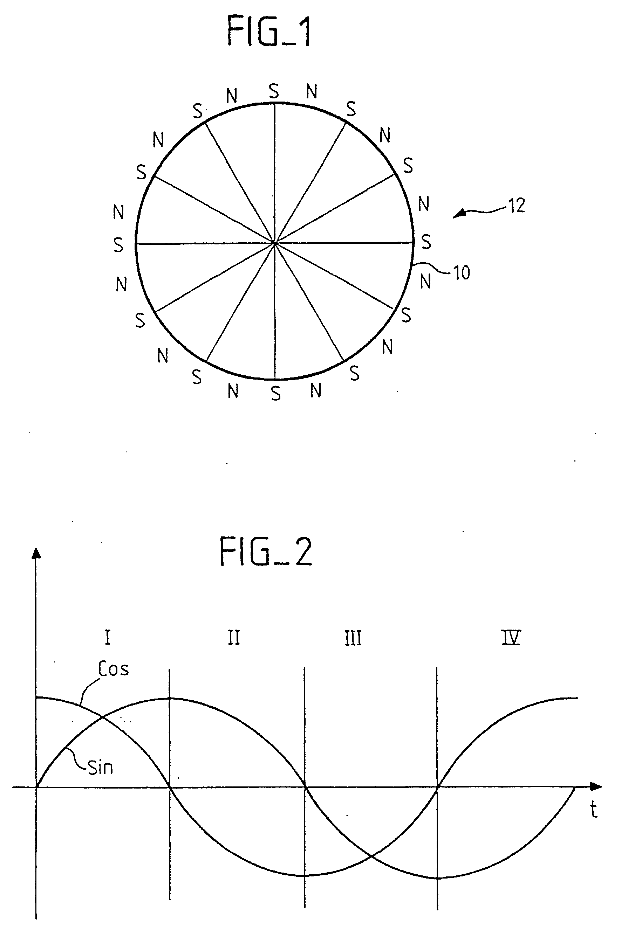

On a schématisé sur la figure 1, N paires de pôles 12, alternativement nord et sud, générés par l'un des bobinages de stator du moteur pas à pas 10.

En l'espèce on a représenté N = douze paires de pôles alternés nord et sud, définissant un pas polaire de 30° sans que cependant ce nombre puisse être considéré comme limitatif.

Lorsque comme celà est le plus fréquent, le moteur 10 comprend deux bobinages, le second bobinage est décalé angulairement d'un demi pas polaire par rapport au premier, soit décalé de 15° pour douze paires de pôles.

Plus précisément la figure 1 illustre la représentation des pôles nord/sud à un instant donné de la séquence de commande appliquée au moteur. Mais les pôles du champ moyen généré par les deux bobines de stator progressent géométriquement dans le temps sous l'effet des signaux électriques de commande appliqués.

A cet effet, typiquement mais non limitativement, les signaux de commande appliqués peuvent être de type sinus sur une bobine de stator et de type cosinus sur l'autre bobine de stator.

On a représenté sur la figure 2 le signal de commande pour parcourir un cycle magnétique. Ce signal est répété sous forme d'une séquence de signaux de commande appliqués au moteur pas à pas.

La séquence pour atteindre une position requise, par exemple un angle mécanique de 360°, comprend elle même une suite de tels cycles.

Un cycle magnétique correspond à une période complète d'une fonction sinus ou cosinus.

Il permet de faire progresser les pôles du stator d'un pas, soit de 30° pour un bobinage à douze pôles. L'axe des temps de la figure 2 est orienté pour un entraînement en sens direct, c'est à dire en éloignement de la butée mécanique du stator. Pour un entraînement en sens rétrograde, le cycle de commande doit être inversé.

Ce cycle magnétique peut être divisé en quatre quadrants. Sur la figure 2, les premier, second, troisième et quatrième secteurs sont référencés respectivemnt I, II, III et IV.

Pour une commande normale, en sens direct ou en sens rétrograde, visant à déplacer l'arbre du rotor vers une position de consigne déterminée, les deux bobinages stator du moteur reçoivent des signaux dont les amplitudes correspondent respectivement, de préférence, à des fonctions en sinus et en cosinus de l'angle recherché et d'amplitude définie, prise comme unité, ou des fonctions équivalentes, par exemple des fonctions évoluant par échelons discrets.

Plus précisément, pour un entraînement vers une position de consigne, le circuit de commande conforme à l'invention est adapté pour appliquer aux bobinages 20 et 22 un nombre entier de cycles complets en sinus et cosinus, égal au nombre entier de pas de paires de pôles correspondant à la déviation mécanique recherchée, additionné d'une fraction d'un tel cycle correspondant à la fraction additionnelle requise de déplacement angulaire pour atteindre la déviation mécanique recherchée.

Pour atteindre un angle de déviation mécanique Φ, par exemple de 100°, pour un stator comprenant deux bobinages générant chacun N paires de poles, par exemple douze paires de pôles, le circuit de commande va appliquer un nombre de cycles complets en sinus/cosinus égal au nombre entier de Φ.N/360° conduisant par exemple à un déplacement mécanique cumulé du rotor de 90°, suivi d'une portion d'un cycle magnétique égal à α = Φ modulo 2π/N, soit par exemple 120° d'un cycle magnétique additionnel conduisant aux 10° additionnels requis de déplacement mécanique.

Pour une commande en sens rétrograde en vue d'un retour à zéro ou d'un maintien en position de zéro, par contre, comme on l'a indiqué précédemment, les moyens générateurs de signaux de commande de rotation du moteur sont adaptés pour au moins atténuer l'amplitude des signaux de commande qui correspondent à un couple négatif appliqué au moteur, sur l'un au moins des secteurs des cycles magnétiques de la séquence de signaux de commande de rotation en sens rétrograde, par rapport aux autres secteurs. On précisera par la suite en regard de la figure 5 un mode préférentiel de mise en oeuvre des signaux de commande pour piloter ce retour à zéro.

Dans le cadre de la présente invention le moteur pas à pas 10 est équipé d'une butée 14 apte à coopérer avec un levier lié à l'arbre de sortie du moteur. Un tel levier peut être formé par exemple d'une aiguille indicatrice liée à cet arbre.

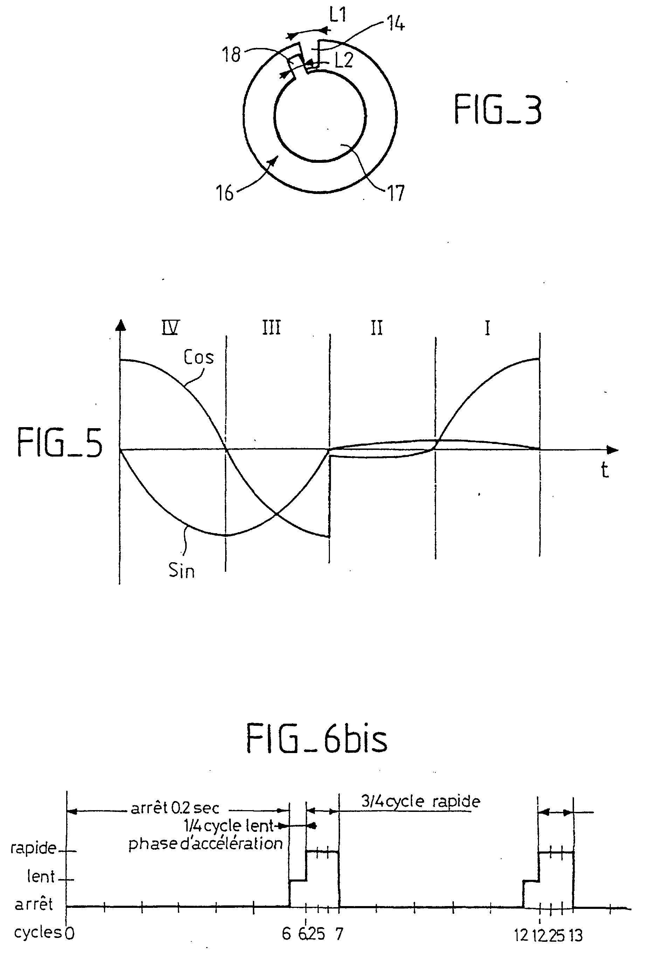

En variante cependant, comme illustré sur la figure 3, un tel levier peut être formé d'une came 16 solidaire directement ou indirectement du rotor. La came 16 peut être formée d'un disque 17 pourvu d'une saillie radiale 18. Cette came 16 présente avantageusement une symétrie par rapport à un plan diamétral de sorte que si son orientation angulaire par rapport à l'arbre du moteur doit bien entendu être contrôlée avec précision, son sens de montage (pile ou face) sur le rotor soit en revanche indifférent.

De préférence, dans le cadre de l'invention, la somme des ouvertures angulaires L1 + L2 de la butée 14 et de ladite saillie 18 associée, est égale à un sous multiple, avantageusement un multiple, du pas polaire.

On supposera par la suite que la butée 14 est positionnée pour coïncider avec l'origine trigonométrique du cycle magnétique. En d'autres termes le levier (aiguille par exemple) peut reposer sur la butée 14 lorsque l'un des bobinages du moteur reçoit un signal maximal (cosinus = 1) tandis que l'autre bobinage reçoit un signal nul (sinus = 0).

Plus précisément dans le cadre de la présente invention, les moyens générateurs de signaux de commande sont de préférence adaptés pour supprimer ou au moins atténuer les signaux (cosinus et sinus) du deuxième secteur trigonométrique II et supprimer ou au moins atténuer le signal en sinus du premier secteur trigonométrique I, les amplitudes du signal en cosinus sur le premier secteur I et les amplitudes des signaux en sinus et en cosinus sur les troisième et quatrième secteurs III, IV étant non altérées.

Dans le cadre de la présente invention, l'atténuation précitée des signaux de commande peut correspondre à une division d'amplitude par 16, par rapport aux autres secteurs.

Les signaux de commande répondant à ce mode de réalisation préférentiel, mais bien entendu non limitatif, sont illustrés sur la figure 5 ci-jointe.

Dans les secteurs IV et III le sinus est négatif donc si le levier lié au rotor (par exemple l'aiguille) repose au préalable sur la butée mécanique 14, le rotor subissant un couple qui sollicite le levier vers cette butée, le levier ne bouge pas.

Le franchissement du secteur II est obtenu grâce à l'inertie du rotor.

Dans le secteur I seul le cosinus est commandé (ou en tout cas le sinus est atténué). Le cosinus tend par conséquent à ramener le levier vers la butée mécanique 14 ou à le maintenir sur celle-ci.

On a représenté sur la figure 4 un circuit de commande 50 conforme à la présente invention.

Ce circuit 50 comprend essentiellement une unité centrale 52, un circuit de sortie 54 et une table de mémoire 56.

La table de mémoire 56 est adaptée pour contenir des données, de préférence numériques, représentant les valeurs trigonométriques des angles à afficher. La table 56 peut contenir par exemple les valeurs en 128 points d'une fonction sinus de 0° à 90°.

L'unité 52 reçoit sur son entrée 53 un signal d'entrée représentant une position de consigne requise pour l'organe entrainé lié à l'arbre de sortie du moteur.

Elle convertit ce signal par traitement selon des modalités bien connues de l'homme de l'art en une valeur représentative de l'angle requis pour l'arbre de sortie du moteur pas à pas.

L'amplitude des signaux en sinus et cosinus devant être appliqués respectivement aux deux bobines 20 et 22 pour atteindre l'angle de déviation recherché est déterminée par lecture de la table 56.

Pour celà les valeurs en sinus sont lues dans la table 56 en lecture normale, c'est-à-dire en commençant la lecture de la table au début de celle-ci, et les valeurs en cosinus sont lues dans la même table 56 en sens inverse, c'est à dire en commençant la lecture de cette table par la fin.

Par ailleurs les valeurs positive et négative des signaux de commande du moteur pas à pas sont obtenues en inversant le sens du courant dans les bobinages 20 et 22.

A cette fin, comme on le voit sur la figure 4, de préférence chaque extrémité des bobinages 20 et 22 est alimentée, de façon connue en soi, par l'intermédiaire d'un pont de deux interrupteurs commandés T30 à T37 rendus alternativement passants selon le sens du courant recherché et reliés respectivement à une tension d'alimentation positive +VCC et à la masse. De tels interrupteurs commandés sont formés de préférence de transistors MOS T31, T33, T35, T37 et T30, T32, T34, T36 respectivement de type N et de type P.

Par ailleurs dans le cadre de la présente invention les interrupteurs T30 à T37 sont alimentés par des signaux en PWM générés par l'étage de sortie 54, c'est à dire des signaux d'amplitude constante et de rapport cyclique variable.

Pour atténuer l'amplitude des signaux (second quadrant II et sinus du premier quadrant I) ce qui revient à diviser les valeurs contenues dans la table 56, l'unité 52 peut procéder simplement par décalage de bits vers la droite des valeurs numériques lues dans cette table 56. Le rapport cyclique correspondant des signaux alors appliqués sur les bobines 20 et 22 sera en conséquence divisé par 16 pour un décalage de 4 bits des valeurs lues dans la table 56.

Le processus de commande de retour à zéro peut être utilisé pour ramener l'organe entrainé (par exemple une aiguille) à zéro, lors de la coupure de l'alimentation du moteur pas à pas. Dans ce cas de préférence il est prévu des moyens de temporisation adaptés pour maintenir l'alimentation électrique provisoirement pendant un temps suffisant pour assurer ce retour à zéro en appliquant au moteur un nombre de cycles de commande en sens rétrograde, comprenant au moins un secteur au moins atténué selon l'invention, supérieur au nombre de cycles correspondant à la position du moteur au moment de la coupure d'alimentation.

Toutefois, de préférence, lors d'une coupure de l'alimentation du moteur pas à pas, en particulier par coupure de la tension du réseau de bord, par exemple à l'arrêt du véhicule, le système est ramené à zéro grâce à des signaux de commande non atténués du type représenté sur la figure 2, de façon classique, puis pour garantir l'atteinte de la position de zéro et le maintien dans celle-ci, quelques cycles de signaux de commande comportant au moins un secteur au moins atténué selon l'invention sont appliqués au stator.

L'application préférentielle de l'invention réside dans le processus de commande de retour à zéro ou de maintien en position de zéro pour garantir la position d'origine du système au moment de l'initialisation d'une utilisation. Une telle initialisation peut être activée à chaque réapparition de l'alimentation électrique du système ou encore à chaque réinitialisation du système sous l'effet d'une commande extérieure, par exemple un circuit de contrôle.

Dans ce cas l'unité 52 est adaptée de préférence pour appliquer au moteur 10, au moment de l'initialisation, un nombre de cycles de commande en sens rétrograde dont au moins un secteur est au moins atténué comme indiqué précédemment (par exemple du type représenté sur la figure 5) au moins égal au nombre de cycles requis pour obtenir la déviation maximale (c'est à dire au moins 12 cycles en sens rétrograde selon le mode de réalisation particulier et non limitatif décrit précédemment).

Selon une modalité de mise en oeuvre préférentielle le retour à zéro ou maintien à zéro est opéré selon la présente invention conformément aux étapes suivantes :
- dans un premier temps, un signal est appliqué à l'une des bobines pour orienter le rotor par rapport à celle-ci,
- dans un second temps, on commande le stator à vitesse réduite pendant un quart de cycle de sinus/cosinus non atténué correspondant au secteur IV,
- puis dans un troisième temps un nombre de cycles magnétiques de commande en sens rétrograde suffisant pour amener le levier contre la butée est appliqué sur le stator à une fréquence supérieure à la fréquence de résonance du rotor équipé, et
- enfin dans un quatrième temps l'unité 52 applique au stator des cycles magnétiques de commande en sens rétrograde à une fréquence inférieure à la fréquence de résonance du stator équipé.

La séquence correspondante de signaux est schématisée sur la figure 6.

Cette séquence permet d'obtenir un retour à zéro ou un maintien à zéro satisfaisant dans des conditions variées de tension d'alimentation, de poids d'organes entrainés (par exemple d'aiguille), et de balourds d'organe à déplacer.

Le premier temps permet d'aligner le rotor du moteur sur l'un des pôles (à un pas de paires de pôles près, par exemple 30° près) le plus proche et par conséquent sur l'origine d'un cycle magnétique. La durée de ce premier temps doit être suffisante pour stabiliser le rotor. Elle est typiquement de l'ordre de 200ms.

Le second temps (quart de cycle de sin/cos correspondant au secteur IV) permet de créer une phase d'accélération qui assure un bon démarrage du moteur même avec une tension d'alimentation faible ou un couple résistant dû au balourd à remonter. Pour cette phase d'accélération, la commande est le secteur IV où les signaux en sinus et cosinus sont complets.

A titre d'exemple le troisième temps peut être formé de huit cycles 3/4 représentant 3/4 de tour mécanique d'aiguille. Ce troisième temps commence par le secteur III qui correspond à un secteur dans lequel les signaux ne sont pas atténués. L'utilisation d'une fréquence supérieure à la fréquence de résonance permet d'obtenir une vitesse de rotor suffisante pour passer le secteur II. Ce troisième temps permet également de déplacer l'organe entrainé (par exemple l'aiguille), malgré un balourd, dans la phase ascendante de son déplacement, sachant que la plupart des indicateurs ont un cadran sensiblement vertical.

Le quatrième temps peut correspondre par exemple à six cycles magnétiques soit 1/2 tour de rotor.

Bien entendu la séquence illustrée sur la figure 6 peut faire l'objet de diverses variantes. Par exemple comme illustrée sur la figure 6bis, cette séquence peut être entrecoupée de poses successives comparables au premier temps, suivies d'un redémarrage grâce à des étapes comparables aux deuxième et troisième temps précités.

Plus précisément, on a schématisé sur la figure 6bis, une séquence qui comprend de manière itérative :
- un premier temps, par exemple d'un durée de l'ordre de 200ms, pendant lequel un signal est appliqué à l'un des enroulements, pour stabiliser le rotor,
- un second temps lors duquel on commande le stator à vitesse réduite pendant un quart de cycle sinus/cosinus non atténué correspondant au secteur IV, et
- un troisième temps lors duquel on applique au stator, à vitesse rapide, 3/4 cycle correspondant aux secteurs III, II et I de la figure 5.

Le nombre d'itérations ainsi définies peut être égal au nombre de N de cycles requis pour parcourir l'angle maximal autorisé, par exemple un tour complet.

Par rapport aux dispositions illustrées sur la figure 6, la variante représentée sur la figure 6bis permet de supprimer tout risque de résonance et de rebond sur la butée mécanique.

De préférence les fréquences dites supérieure et inférieure à la fréquence de résonance du rotor équipé sont dans un rapport de l'ordre de 3. Par exemple la fréquence supérieure à la fréquence de résonance du rotor équipé peut être de l'ordre de 3^{1/2} la fréquence de résonance du rotor équipé, tandis que la fréquence inférieure à la fréquence de résonance du rotor équipé peut être de l'ordre de 1/3^{1/2} ladite fréquence de résonance du rotor équipé.

Par rotor équipé on entend le rotor du moteur pas à pas pourvu de l'organe entrainé (par exemple l'aiguille indicatrice) porté par son arbre de sortie. La fréquence de résonance du rotor équipé varie par conséquent en fonction de chaque application et les fréquences supérieure et inférieure appliquées au stator doivent être adaptées en conséquence.

La présente invention permet de réaliser des indicateurs à moteurs pas à pas économiques et présentant un retour fiable à zéro.

En effet lorsque la commande en sens rétrograde précitée est appliquée, le rotor et le levier associé ne sont sollicités que vers la butée. Ils ne peuvent effectuer alternativement un déplacement en sens direct et un déplacement en sens rétrograde, comme celà pouvait se produire dans les réalisations antérieures classiques. Ainsi selon l'invention, il n'y a plus aucun martèlement sur la butée ce qui évite la génération de bruit parasite, particulièrement avec la séquence illustrée sur la figure 6bis.

Bien entendu la présente invention ne doit pas être considérée comme limitée au mode de réalisation particulier qui vient d'être décrit, mais s'étend à toutes variantes conformes à son esprit.

Selon une autre caractéristique préférentielle de l'invention, l'organe entrainé (par exemple l'aiguille) présente un certain déséquilibre mécanique par rapport à son axe de rotation et est adapté pour reposer sur la butée mécanique en étant superposée à celle-ci comme on l'a schématisé sur la figure 7, en position de zéro. Cette disposition permet un automaintien de l'organe entrainé ( par exemple l'aiguille) en position de zéro, sous son propre poids, y compris après coupure de l'alimentation électrique. Un tel déséquilibre empêche également une vibration lorsque la commande de remise à zéro est initiée alors que l'organe entrainé est déjà dans la position dite de zéro.

Pour obtenir un positionnement précis de la butée mécanique, de préférence, on chasse celle-ci après avoir alimenté la bobine en cosinus correspondant à la position de zéro.

Bien entendu dans l'hypothèse où la butée mécanique ne coïncidrait pas avec l'origine trigonométrique d'un cycle magnétique, il conviendrait d'adapter en conséquence les secteurs atténués par rapport aux dispositions décrites précédemment.

Selon une autre variante de réalisation applicable en particulier pour les moteurs équipés d'un démultiplicateur, la séquence de remise à zéro comprend des cycles rapides sans accélération suivis de quelques cycles avec arrêt, toujours sans accélération, pour éviter un rebond sur la butée 14.

## Revendications

1. Système d'entraînement comprenant un moteur pas à pas (10), un levier lié à l'arbre du moteur pas à pas, une butée mécanique de zéro (14) apte à arrêter le mouvement du rotor lorsque le levier atteint la butée et des moyens (50) générateurs de séquences de signaux électriques de commande de rotation du moteur respectivement en sens direct et en sens rétrograde, lesquelles séquences de signaux correspondent à des cycles magnétiques réguliers successifs, système où les moyens générateurs de signaux de commande de rotation du moteur sont adaptés pour au moins atténuer l'amplitude des signaux de commande qui correspondent à un couple négatif appliqué au moteur, sur l'un au moins (I, II) des secteurs des cycles magnétiques de la séquence de signaux de commande de rotation en sens rétrograde, par rapport aux autres secteurs, pour une commande de retour à zéro, les signaux de commande qui correspondent à un couple négatif et qui sont par conséquent atténués lors d'un déplacement en sens rétrograde, étant ceux qui tendent à éloigner le levier de la butée lorsque, au moment de l'application de ces signaux, le levier repose sur la butée.

2. Système d'entraînement selon la revendication 1, **caractérisé par le fait que** le levier est formé d'une aiguille indicatrice liée à l'arbre du moteur.

3. Système d'entraînement selon la revendication 1, **caractérisé par le fait que** le levier est formé d'une came liée au rotor du moteur.

4. Système d'entraînement selon l'une des revendications 1 à 3, **caractérisé par le fait que** la butée (14) est positionnée pour coïncider avec l'origine trigonométrique d'un cycle magnétique.

5. Système d'entraînement selon l'une des revendications 1 à 4, **caractérisé par le fait que** les moyens générateurs de signaux sont adaptés pour au moins atténuer les signaux (cosinus et sinus) du deuxième secteur trigonométrique (II).

6. Système d'entraînement selon l'une des revendications 1 à 5, **caractérisé par le fait que** les moyens générateurs de signaux sont adaptés pour au moins atténuer l'un des signaux (sinus) du premier secteur trigonométrique (I).

7. Système d'entraînement selon l'une des revendications 1 à 6, **caractérisé par le fait que** les moyens générateurs de signaux sont adaptés pour au moins atténuer les signaux (cosinus et sinus) du deuxième secteur trigonométrique (II) et au moins atténuer l'un des signaux (sinus) du premier secteur trigonométrique (I).

8. Système d'entraînement selon l'une des revendications 1 à 7, **caractérisé par le fait que** les moyens générateurs de signaux sont adaptés pour supprimer les signaux (cosinus et sinus) du deuxième secteur trigonométrique (II).

9. Système d'entraînement selon l'une des revendications 1 à 8, **caractérisé par le fait que** les moyens générateurs de signaux sont adaptés pour supprimer l'un des signaux (sinus) du premier secteur trigonométrique (I).

10. Système d'entraînement selon l'une des revendications 1 à 9, **caractérisé par le fait que** l'atténuation des signaux de commande correspond à une division d'amplitude, par exemple par 16, par rapport aux autres secteurs.

11. Système d'entraînement selon l'une des revendications 1 à 10, **caractérisé par le fait que** l'atténuation des signaux de commande est obtenue par décalage vers la droite de valeurs numériques représentant les valeurs trigonométriques des angles à afficher stockées dans une table de mémoire (56).

12. Système d'entraînement selon l'une des revendications 1 à 11, **caractérisé par le fait que** le processus de retour à zéro est mis en oeuvre à l'initialisation du système.

13. Système d'entraînement selon l'une des revendications 1 à 12, **caractérisé par le fait que** les moyens générateurs sont adaptés pour appliquer au moteur un nombre de cycles de commande en sens rétrograde supérieur au nombre de cycles correspondant à l'angle de déviation maximale.

14. Système d'entraînement selon l'une des revendications 1 à 13, **caractérisé par le fait que** les moyens générateurs sont adaptés pour générer à l'origine d'un processus de retour à zéro, un signal apte à orienter le rotor sur l'origine d'un cycle magnétique.

15. Système d'entraînement selon l'une des revendications 1 à 14, **caractérisé par le fait que** les moyens générateurs sont adaptés pour générer des signaux à une fréquence différente de la fréquence de résonance mécanique du rotor équipé.

16. Système d'entraînement selon l'une des revendications 1 à 15, **caractérisé par le fait que** les moyens générateurs sont adaptés pour générer successivement des signaux à une fréquence supérieure, puis à une fréquence inférieure à la fréquence de résonance mécanique du rotor équipé.

17. Système d'entraînement selon l'une des revendications 1 à 16, **caractérisé par le fait que** les moyens générateurs sont adaptés pour opérer le retour à zéro conformément aux étapes suivantes :
- dans un premier temps, un signal est appliqué à l'une des bobines pour orienter le rotor par rapport à celle-ci,
- dans un second temps, le stator est commandé à vitesse réduite pendant un quart de cycle de sinus/cosinus non atténué correspondant au secteur IV,
- puis dans un troisième temps un nombre de cycles de commande en sens rétrograde suffisant pour amener le levier contre la butée est appliqué sur le stator à une fréquence supérieure à la fréquence de résonance du rotor équipée, et
- enfin dans un quatrième temps le stator reçoit des cycles de commande en sens rétrograde à une fréquence inférieure à la fréquence de résonance du stator équipé.

18. Système d'entraînement selon l'une des revendications 1 à 16, **caractérisé par le fait que** les moyens générateurs sont adaptés pour opérer le retour à zéro grâce à une séquence qui comprend de manière itérative :
- un premier temps pendant lequel un signal est appliqué à l'un des enroulements, pour stabiliser le rotor,
- un second temps pendant lequel un quart de cycle de sinus/cosinus complet est appliqué aux enroulements du stator, à vitesse lente, et
- un troisième temps pendant lequel 3/4 cycles correspondant aux secteurs suivants d'un cycle de sinus/cosinus, au moins atténués pour les secteurs délivrant un couple négatif, sont appliqués aux enroulements du stator.

19. Système d'entraînement selon la revendication 18, **caractérisé par le fait que** le nombre d'itérations est égal au nombre de cycles requis pour parcourir l'angle maximal autorisé.

20. Système d'entraînement selon l'une des revendications 18 ou 19, **caractérisé par le fait que** le nombre d'itérations est égal au nombre N de paires de poles du stator.

21. Système d'entraînement selon l'une des revendications 1 à 20, **caractérisé par le fait que** le moteur pas à pas comprend deux bobinages de stator alimentés respectivement en sinus et en cosinus, une butée qui coïncide avec l'origine d'un cycle magnétique de commande de ces bobinages et des moyens de commande adaptés pour au moins atténuer les signaux de commande en sinus et cosinus du deuxième secteur (II) et les signaux de commande en sinus du premier secteur (I) des cycles magnétiques, lors d'une séquence de commande en sens rétrograde, par rapport aux autres secteurs.

22. Système d'entraînement selon l'une des revendications 1 à 21, **caractérisé par le fait que** l'organe entrainé, formé de préférence d'une aiguille, présente un déséquilibre mécanique par rapport à son axe de rotation.

23. Système d'entraînement selon l'une des revendications 1 à 22, **caractérisé par le fait que** la somme des largeurs (L1) de la butée mécanique fixe (14) et (L2) d'une dissymétrie (18) prévue sur une came (16) liée au rotor est égale à un sous-multiple, avantageusement un multiple du pas polaire.

## Claims

1. A drive system comprising a stepper motor (10), a lever connected to the shaft of the stepper motor, a zero mechanical abutment (14) suitable for stopping the movement of the rotor when the lever reaches the abutment, and means (50) for generating sequences of electrical signals for controlling rotation of the rotor respectively in the forward direction and in the reverse direction, which signal sequences correspond to regular successive magnetic cycles, in which system, the control signal generator means for controlling rotation of the motor are adapted to at least attenuate the amplitude of the control signals that correspond to a negative torque being applied to the motor, in at least one (I, II) of the sectors of the magnetic cycles of the rotary control signal sequence in the reverse direction, relative to the other sectors for a return to zero command, the control signals which correspond to a negative torque and which are consequently attenuated during displacement in the reverse direction, being those signals which tend to move the lever away from the abutment if the lever is resting against the abutment at the moment when said signals are applied.

2. A drive system according to claim 1, **characterized by** the fact that the lever is formed by an indicator pointer connected to the shaft of the motor.

3. A drive system according to claim 1, **characterized by** the fact that the lever is formed by a cam constrained to rotate with the motor.

4. A drive system according to any one of claims 1 to 3, **characterized by** the fact that the abutment (14) is positioned to coincide with the trigonometric origin of a magnetic cycle.

5. A drive system according to any one of claims 1 to 4, **characterized by** the fact that the signal generator means are adapted to at least attenuate the (cosine and sine) signals of the second trigonometric sector (II).

6. A drive system according to any one of claims 1 to 5, **characterized by** the fact that the signal generator means are adapted to at least attenuate one (sine) of the signals of the first trigonometric sector (I).

7. A drive system according to any one of claims 1 to 6, **characterized by** the fact that the signal generator means are adapted to at least attenuate the (cosine and sine) signals of the second trigonometric sector (II) and to at least attenuate one (sine) of the signals of the first trigonometric sector (I).

8. A drive system according to any one of claims 1 to 7, **characterized by** the fact that the signal generator means are adapted to eliminate the (cosine and sine) signals of the second trigonometric sector (II).

9. A drive system according to any one of claims 1 to 8, **characterized by** the fact that the signal generator means are adapted to eliminate one (sine) of the signals of the first trigonometric sector (I).

10. A drive system according to any one of claims 1 to 9, **characterized by** the fact that the attenuation of the control signals corresponds to amplitude being divided, e.g. by 16, relative to the other sectors.

11. A drive system according to any one of claims 1 to 10, **characterized by** the fact that the control signals are attenuated by right shifting digital values representing the trigonometric values of the angles to be displayed and stored in a memory table (56).

12. A drive system according to any one of claims 1 to 11, **characterized by** the fact that the return to zero process is implemented when the system is initiated.

13. A drive system according to any one of claims 1 to 12, **characterized by** the fact that the generator means are adapted to apply to the motor a number of reverse direction control cycles that is greater than the number of control cycles that corresponds to the maximum deflection angle.

14. A drive system according to any one of claims 1 to 13, **characterized by** the fact that the generator means are adapted, at the beginning of a return to zero process, to generate a signal suitable for orienting the rotor to the origin of a magnetic cycle.

15. A drive system according to any one of claims 1 to 14, **characterized by** the fact that the generator means are adapted to generate signals at a frequency which is different from the mechanical resonance frequency of the fitted rotor.

16. A drive system according to any one of claims 1 to 15, **characterized by** the fact that the generator means are adapted successively to generate signals at a frequency that is greater than and then at a frequency which is less than the mechanical resonance frequency of the fitted rotor.

17. A drive system according to any one of claims 1 to 16, **characterized by** the fact that the generator means are adapted to operate a return to zero in compliance with the following steps:
· initially, a signal is applied to one of the coils to orient the rotor relative thereto;
· secondly, the stator is operated at slow speed during a non-attenuated quarter of the sine/cosine cycle corresponding to sector IV;
· then, thirdly, reverse-direction control cycles are applied to the stator in number sufficient to bring the lever against the abutment and at a frequency greater than the resonant frequency of the treated rotor; and
· finally, fourthly the stator receives control cycles in the reverse direction at a frequency lower than the resonant frequency of the fitted stator.

18. A drive system according to any one of claims 1 to 16, **characterized by** the fact that the generator means are adapted to implement return to zero by a sequence comprising the following in iterative manner:
· a first period during which a signal is applied to one of the windings to stabilize the rotor;
· a second period during which a complete quarter of the sine/cosine cycle is applied to the windings of the rotor at slow speed; and
a third period during which three out of four cycles corresponding to the following sectors of a sine/cosine cycle are applied to the windings of the stator, at least in attenuated form for the sectors that deliver negative torque.

19. A drive system according to claim 18, **characterized by** the fact that the number of iterations is equal to the number of cycles required for travelling through the maximum authorized angle.

20. A drive system according to claim 18 or claim 19, **characterized by** the fact that the number of iterations is equal to the number N of pairs of stator poles.

21. A drive system according to any one of claims 1 to 20, **characterized by** the fact that the stepper motor has two stator coils fed respectively with the sine and with the cosine, an abutment which corresponds to the origin of a magnetic control cycle for the coils, and control means adapted at least to attenuate the sine and cosine control signals of the second sector (II) and the sine control signals of the first sector (I) of the magnetic cycles during a reverse direction control sequence, in comparison with the other sectors.

22. A drive system according to any one of claims 1 to 21, **characterized by** the fact that the driven member, preferably in the form of a needle, presents mechanical unbalance about its axis of rotation.

23. A drive system according to any one of claims 1 to 22, **characterized by** the fact that the sum of the width (L1) of the stationary mechanical abutment (14) and the width (L2) of an asymmetry (18) provided on a cam (16) connected to the rotor is equal to a submultiple and advantageously to a multiple of the pole pitch.

## Patentansprüche

1. Antriebssystem, das einen Schrittmotor (10), einen mit der Welle des Schrittmotors verbundenen Hebel, einen mechanischen Nullanschlag (14), der geeignet ist, die Bewegung des Rotors zu stoppen, wenn der Hebel den Anschlag erreicht, und Mittel (50) zum Erzeugen von Sequenzen elektrischer Drehsteuersignale des Motors jeweils in Vorwärtsrichtung und in Rückwärtsrichtung umfaßt, wobei die Signalsequenzen den aufeinanderfolgenden gleichmäßigen magnetischen Zyklen entsprechen, und das System oder die Mittel zum Erzeugen der Drehsteuersignale des Motors geeignet sind, um wenigstens die Amplitude der Steuersignale, die einem an den Motor angelegten negativen Moment entsprechen, auf wenigstens einem (I, II) der Sektoren der magnetischen Zyklen der Sequenz der Drehsteuersignale in Rückwärtsrichtung bezüglich der anderen Sektoren, für einen Rückkehr-zu-null-Befehl, zu dämpfen, wobei die Steuersignale, die einem negativen Moment entsprechen und die folglich während einer Verstellung in Rückwärtsrichtung gedämpft werden, diejenigen sind, die den Hebel gewöhnlich vom Anschlag entfernen, wenn, zum Zeitpunkt des Anlegens dieser Signale, der Hebel auf dem Anschlag ruht.

2. Antriebssystem nach Anspruch 1, **dadurch gekennzeichnet, daß** der Hebel aus einem mit der Welle des Motors verbundenen Anzeigezeiger gebildet ist.

3. Antriebssystem nach Anspruch 1, **dadurch gekennzeichnet, daß** der Hebel aus einer mit dem Motor verbundenen Nocke gebildet ist.

4. Antriebssystem nach einem der Ansprüche 1 bis 3, **dadurch gekennzeichnet, daß** der Anschlag (14) so positioniert ist, daß er mit dem trigonometrischen Ursprung eines magnetischen Zykluses zusammenfällt.

5. Antriebssystem nach einem der Ansprüche 1 bis 4, **dadurch gekennzeichnet, daß** die Mittel zum Erzeugen von Signalen wenigstens zum Dämpfen der Signale (Kosinus und Sinus) des zweiten trigonometrischen Sektors (II) ausgestaltet sind.

6. Antriebssystem nach einem der Ansprüche 1 bis 5, **dadurch gekennzeichnet, daß** die Mittel zum Erzeugen der Signale wenigstens zum Dämpfen eines der Signale (Sinus) des ersten trigonometrischen Sektors (I) ausgestaltet sind.

7. Antriebssystem nach einem der Ansprüche 1 bis 6, **dadurch gekennzeichnet, daß** die Mittel zum Erzeugen der Signale wenigstens zum Dämpfen der Signale (Kosinus und Sinus) des zweiten trigonometrischen Sektors (II) und wenigstens zum Dämpfen eines der Signale (Sinus) des ersten trigonometrischen Sektors (I) ausgestaltet sind.

8. Antriebssystem nach einem der Ansprüche 1 bis 7, **dadurch gekennzeichnet, daß** die Mittel zum Erzeugen der Signale zum Unterdrücken der Signale (Kosinus und Sinus) des zweiten trigonometrischen Sektors (II) ausgestaltet sind.

9. Antriebssystem nach einem der Ansprüche 1 bis 8, **dadurch gekennzeichnet, daß** die Mittel zum Erzeugen der Signale zum Unterdrücken eines der Signale (Sinus) des ersten trigonometrischen Sektors (I) ausgestaltet sind.

10. Antriebssystem nach einem der Ansprüche 1 bis 9, **dadurch gekennzeichnet, daß** die Dämpfung der Steuersignale einer Amplitudenteilung, beispielsweise durch 16, bezüglich der anderen Sektoren entspricht.

11. Antriebssystem nach einem der Ansprüche 1 bis 10, **dadurch gekennzeichnet, daß** die Dämpfung der Steuersignale durch Rechtsverschiebung der Digitalwerte erhalten wird, welche die anzuzeigenden trigonometrischen Winkelwerte darstellen, die in einer Speichertabelle (56) gespeichert sind.

12. Antriebssystem nach einem der Ansprüche 1 bis 11, **dadurch gekennzeichnet, daß** der Rückkehr-zu-null-Prozeß bei der Initialisierung des Systems stattfindet.

13. Antriebssystem nach einem der Ansprüche 1 bis 12, **dadurch gekennzeichnet, daß** die Erzeugungsmittel zum Anlegen einer Anzahl an Steuerzyklen in Rückwärtsrichtung an den Motor ausgestaltet sind, die größer als die Anzahl der dem Winkel der Maximalabweichung entsprechenden Zyklen ist.

14. Antriebssystem nach einem der Ansprüche 1 bis 13, **dadurch gekennzeichnet, daß** die Erzeugungsmittel zum Erzeugen eines Signals ausgehend von einem Rückkehr-zu-null-Prozeß ausgestaltet sind, das geeignet ist, den Rotor am Ursprung eines magnetischen Zykluses auszurichten.

15. Antriebssystem nach einem der Ansprüche 1 bis 14, **dadurch gekennzeichnet, daß** die Erzeugungsmittel zum Erzeugen von Signalen mit einer zu der mechanischen Resonanzfrequenz des ausgestatteten Rotors unterschiedlichen Frequenz ausgestaltet sind.

16. Antriebssystem nach einem der Ansprüche 1 bis 15, **dadurch gekennzeichnet, daß** die Erzeugungsmittel zum aufeinanderfolgenden Erzeugen von Signalen mit einer höheren Frequenz, dann mit einer niedrigeren Frequenz als die mechanische Resonanzfrequenz des ausgestatteten Rotors ausgestaltet sind.

17. Antriebssystem nach einem der Ansprüche 1 bis 16, **dadurch gekennzeichnet, daß** die Erzeugungsmittel zum Bewirken des Rückkehr-zu-null-Vorgangs gemäß folgender Schritte ausgestaltet sind:
- während einer ersten Zeitdauer wird ein Signal an eine der Spulen angelegt, um den Rotor bezüglich dieser zu orientieren,
- während einer zweiten Zeitdauer wird der Stator während eines nicht gedämpften Sinus/Kosinus-Zyklusviertels, das dem Sektor IV entspricht, mit reduzierter Geschwindigkeit gesteuert,
- dann wird während einer dritten Zeitdauer eine Anzahl an Steuerzyklen in Rückwärtsrichtung, die ausreicht, den Hebel gegen den Anschlag zu bringen, an den Stator mit einer höheren Frequenz als die Resonanzfrequenz des ausgestatteten Rotors angelegt, und
- schließlich empfängt während einer vierten Zeitdauer der Stator Steuerzyklen in Rückwärtsrichtung mit einer kleineren Frequenz als die Resonanzfrequenz des ausgestatteten Stators.

18. Antriebssystem nach einem der Ansprüche 1 bis 16, **dadurch gekennzeichnet, daß** die Erzeugungsmittel zum Bewirken des Rückkehr-zu-null-Vorgangs mittels einer Sequenz ausgestaltet sind, die iterativ folgendes umfaßt:
- eine erste Zeitdauer, während der ein Signal an eine der Wicklungen angelegt wird, um den Rotor zu stabilisieren,
- eine zweite Zeitdauer, während der ein vollständiges Sinus/Kosinus-Zyklusviertel an die Wicklungen des Stators angelegt wird, mit langsamer Geschwindigkeit, und
- eine dritte Zeitdauer, während der 3/4 Zyklen, entsprechend den einem Sinus/Kosinus-Zyklus folgenden Sektoren, die wenigstens für die ein negatives Moment liefernden Sektoren gedämpft sind, an die Wicklungen des Stators angelegt werden.

19. Antriebssystem nach Anspruch 18, **dadurch gekennzeichnet, daß** die Anzahl an Iterationen gleich der Anzahl an Zyklen ist, die zum Durchlaufen des maximal zulässigen Winkels benötigt werden.

20. Antriebssystem nach einem der Ansprüche 18 oder 19, **dadurch gekennzeichnet, daß** die Anzahl an Iterationen gleich der Anzahl N an Polpaaren des Stators ist.

21. Antriebssystem nach einem der Ansprüche 1 bis 20, **dadurch gekennzeichnet, daß** der Schrittmotor zwei Statorspulen, die mit einem Sinus bzw. einem Kosinus versorgt werden, einen Anschlag, der mit dem Ursprung eines magnetischen Steuerzykluses dieser Spulen zusammenfällt, und Steuermittel umfaßt, die zumindest zum Dämpfen der Sinus- und Kosinus-Steuersignale des zweiten Sektors (II) und der Sinus-Steuersignale des ersten Sektors (I) der magnetischen Zyklen, während einer Steuersequenz in Rückwärtsrichtung, bezüglich der anderen Sektoren ausgestaltet sind.

22. Antriebssystem nach einem der Ansprüche 1 bis 21, **dadurch gekennzeichnet, daß** das angetriebene Organ, das vorzugsweise als ein Zeiger ausgebildet ist, ein mechanisches Ungleichgewicht bezüglich seiner Rotationsachse aufweist.

23. Antriebssystem nach einem der Ansprüche 1 bis 22, **dadurch gekennzeichnet, daß** die Summe der Breiten (L1) des ortsfesten mechanischen Anschlags (14) und (L2) einer Asymmetrie (18), die an einer mit dem Rotor verbundenen Nocke (16) vorgesehen ist, gleich einem Untervielfachen, bevorzugt einem Vielfachen, des Polschrittes ist.
